# EUROPÄISCHE PATENTSCHRIFT

(11) **EP 0 360 915 B1**
(45) Veröffentlichungstag und Bekanntmachung des Hinweises auf die Patenterteilung: **16.06.1993**
(21) Anmeldenummer: 88116231.7
(22) Anmeldetag: 30.09.1988
(51) Int. Cl.: H03K 17/00, G06F 1/04

(54) **Sensorschaltanordnung**
Sensor switching arrangement
Circuit de commutation comportant un capteur

(43) Veröffentlichungstag der Anmeldung: 04.04.1990
(73) Patentinhaber: SIEMENS AKTIENGESELLSCHAFT, 80333 München (DE)
(72) Erfinder: Draxelmayr Dieter Dipl. Ing., A-9500 Villach (AT)

(56) Entgegenhaltungen:
- DE-A- 3 007 908
- US-A- 4 722 070
- PATENT ABSTRACTS OF JAPAN vol. 8, no. 33 (P-254) 1470 14 Februar 1984, & JP-A-58 186817 (NIPPON DENSO)

## Beschreibung

Die Erfindung betrifft eine Sensorschaltanordnung nach dem Oberbegriff des Patentanspruchs 1.

Für viele Schaltungen besteht die Anforderung, alternativ eine digitale und eine weitere, vorzugsweise eine zweite digitale Signalquelle einsetzen zu können. Beispielsweise ist für viele integrierte Schaltungen eine externe Klemme vorgesehen, an die entweder ein externer Taktgenerator oder eine frequenzbestimmende Komponente, z.B. ein Widerstand oder ein Kondensator, für einen mitintegrierten internen Taktgenerator angeschlossen werden soll. Allerdings ist innerhalb der integrierten Schaltung eine Schaltungsanordnung erforderlich, die den wahlweisen Betrieb des internen oder des externen Taktgenerators ermöglicht.

Es ist die integrierte Schaltung Analog Devices AD 7582 bekannt, die als frequenzbestimmende Komponente für den internen Taktgenerator einen oder mehrere Kondensatoren hat. Für die Kondensatoren wiederum ist üblicherweise eine (Ent-)Ladestromquelle erforderlich. Beim Anschluß eines externen Taktgenerators an die äußere Klemme zieht dieser den internen Taktgenerator üblicherweise mit, d.h. der externe Generator muß den mitlaufenden (Ent-)Ladestrom für den internen Generatorbetrieb mittreiben. Auf diese Weise entstehen Verluste. Andererseits kann der Kondensator nicht beliebig klein gewählt werden, da er größer als die parasitären Kapazitäten aus den Anschlußflächen (Pads), den Verbindungen (Bonds), dem Gehäuse, der Platine und anderen sein muß. Für den Betrieb sind damit aber relativ große Ströme notwendig, wenn höhere Taktfrequenzen erreicht werden sollen, da kleine Ströme zu kleinen Amplituden und damit zu einer großen Störempfindlichkeit führen. Eine Sensor- und Schaltfunktion ist durch die Anordnung nicht gegeben.

Aus der DE-A- 30 07 908 ist eine elektronische Uhr bekannt, die für eine digitale und eine weitere Signalquelle einen automatischen Schalter vorsieht, der als Schwellwertschalter ausgebildet sein kann. Die Umschaltung erfolgt, wenn der Signalwert der regulär durchgeschalteten Signalquelle einen störungsfreien Betrieb der Uhr nicht mehr gewährleistet. Einzelheiten des automatischen Schalters sind nicht beschrieben.

Der Erfindung liegt die Aufgabe zugrunde, eine Schaltungsanordnung anzugeben, die als Sensorschaltung die Art der externen Beschaltung feststellt und eine definierte Umschaltung zwischen beiden Signalquellen derart ermöglicht, daß bei hohen Frequenzen vergleichsweise kleine Ströme und niedrige Verluste möglich sind.

Diese Aufgabe wird bei einer Anordnung der eingangs genannten Art erfindungsgemäß durch die Merkmale des kennzeichnenden Teils des Patentanspruchs 1 gelöst.

Die erfindungsgemäß Sensorschaltanordnung hat den Vorteil, daß der Sensorteil die Art der externen Beschaltung entweder mit einer digitalen Signalquelle oder einem funktionsbestimmenden Element der weiteren Signalquelle feststellt und davon abhängig nur den Ausgang einer Signalquelle durchschaltet. Die Erfindung hat weiterhin den Vorteil, daß die Ströme für die weitere Signalquelle bis zu hohen Frequenzen niedrig bleiben können, ohne daß die Störsicherheit beeinträchtigt wird. Weiterhin bietet die Erfindung den Vorteil, daß eventuell erforderliche Zeitkonstanten mit Hilfe einer Integrationskapazität realisiert werden können. Vorteilhaft wird dabei die Integrationskapazität durch die Geometrie der Transistoren eines Verstärker- oder Schmitt-Trigger-Elements ausgebildet. Schließlich besitzt die Erfindung den Vorteil, daß beim Anschluß einer digitalen Signalquelle die weitere Signalquelle vollständig abgeschaltet werden kann und damit Verluste relativ gering gehalten werden können.

Weiterbildungen des Erfindungsgedankens sind in abhängigen Ansprüchen gekennzeichnet.

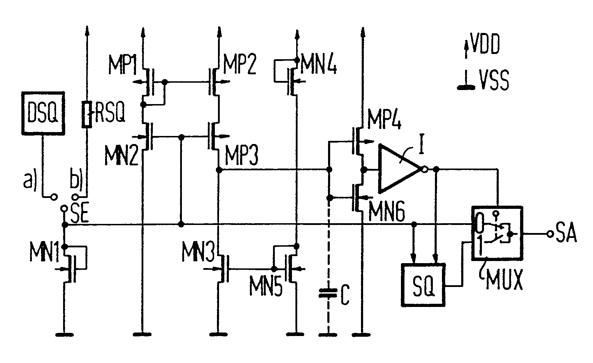

Die Erfindung wird im folgenden anhand eines in der Figur der Zeichnung dargestellten Ausführungsbeispiels näher erläutert.

Die Figur zeigt ein schematisches Schaltbild einer erfindungsgemäßen Sensorschaltanordnung mit den wahlweisen Beschaltungsalternativen
a) digitale Signalquelle und
b) weitere Signalquelle.

Gemäß der Figur besteht der Sensorteil der erfindungsgemäßen Sensorschaltanordnung aus einer über die Steuerklemme SE steuerbaren Stromquelle, die gegen eine Feststromquelle arbeitet. Die steuerbare Stromquelle wird durch den Stromspiegel MP1 und MP2 gebildet, von denen MP1 als Diode geschaltet ist. Jeweils in Reihe zu einem der beiden Stromquellentransistoren MP1 und MP2 liegt ein weiterer Transistor MN2 und MP3, deren gemeinsamer Gateanschluß mit der Steuerklemme SE verbunden ist. MN2 und MP3 sind bezüglich ihres Leitungstyps zueinander komplementär. Es ist auch möglich, daß MN2 und MP3 mit ihren Ausgangskreisen in Reihe und in Reihe zu einem der beiden Stromquellentransistoren MP1 und MP2 liegen.

Eine Feststromquelle aus den Transistoren MN3 bis MN5 arbeitet gegen die zuvor beschriebene steuerbare Stromquelle. Die Transistoren MN3 und MN5 bilden einen Stromspiegel, bei dem MN5 als Diode geschaltet ist. Der Transistor MN4 ist ebenfalls als Diode bzw. als Lastelement geschaltet. Der Ausgangskreis des Transistors MN3 liegt in Serie zum Ausgangskreis des Transistors MP3 und der Verbindungspunkt der Ausgangskreise stellt den Ausgang der Sensor-Teilschaltung dar. Die Transistoren MN3 bis MN5 der Feststromquelle sind im Ausführungsbeispiel n-leitend, während die Transistoren MP1 und MP2 der über die Steuertransistoren MN2 und MP3 steuerbaren Stromquelle p-leitend sind. Die steuerbare Stromquelle und die Feststromquelle sind Komplementär-Stromquellen und bilden eine steuerbare Stromquellenanordnung, die von einer Versorgungsspannungsquelle mit der zwischen den Anschlüssen VSS und VDD anliegenden Spannung versorgt wird. Die Steuerklemme SE ist weiterhin über ein Potentialsteuerelement, das im Ausführungsbeispiel durch den als Diode geschalteten Transistor MN1 gebildet wird, mit dem Bezugspotential VDD der Schaltung verbunden. Zusätzlich führt die Klemme SE auf einen Dateneingang eines Multiplexers MUX und auf einen Steuereingang der weiteren Signalquelle SQ.

Wahlweise ist an die Steuerklemme SE eine digitale Signalquelle DSQ als Alternative a) und ein Widerstand RSQ als Alternative b) anschließbar. Der Widerstand RSQ liegt mit seinem anderen Anschluß am Versorgungsanschluß VDD.

Der steuerbaren Stromquellenanordnung ist ausgangsseitig ein durch die Transistoren MP4 und MN6 gebildeter Inverter nachgeschaltet. Es handelt sich um einen Inverter mit komplementären MOS-Transistoren. Diesem Inverter ist ein weiterer Inverter I nachgeschaltet, der ausgangsseitig einerseits den Adresseneingang des Multiplexers MUX und andererseits einen Eingang der weiteren Signalquelle SQ steuert. Der Ausgang SA des Multiplexers MUX bildet den Ausgang der Sensorschaltanordnung. Der Multiplexer kann je nach Anwendungsfall als Analog- oder Digitalmultiplexer ausgeführt sein. Im Ausführungsbeispiel ist er durch zwei gesteuerte Transferschalter symbolisch dargestellt. Der Inverter I ist oft vorteilhaft, aber nicht unbedingt erforderlich. Insbesondere beim Einsatz eines Schmitt-Triggers entfällt er.

Nachfolgend wird die Funktion der erfindungsgemäßen Sensorschaltanordnung beschrieben.

Die Sensor-Teilschaltung bestimmt, ob eine digitale Signalquelle an der Steuerklemme SE angeschlossen ist oder nicht. Vorausgesetzt wird, daß die digitale Signalquelle wohldefinierte Logikpegel liefert und die Flankensteilheit ausreichend ist. Die Sensor-Teilschaltung ist erfindungsgemäß so ausgelegt, daß das Sensorkriterium der Spannungswert an der Steuerklemme SE ist. Die Sensor-Teilschaltung arbeitet hochohmig, so daß die an der Steuerklemme SE angeschlossenen Elemente gering belastet werden.

In der Alternative a) ist die digitale Signalquelle DSQ an der Steuerklemme SE angeschlossen. Der Eingangszweig der steuerbaren Stromquelle aus den Transistoren MP1 und MN2 hat die Eigenschaft, daß nur dann Strom, dessen Größe durch die Geometrie des Steuertransistors MN2 beeinflußbar ist, fließt, wenn die Eingangsspannung an der Steuerklemme SE über einem bestimmten Wert liegt. Mit steigender Gate-Steuerspannung wird der Strom durch den Eingangszweig immer größer. Da MP1 und MP2 einen Stromspiegel bilden, fließt der Strom im Eingangszweig auch im Ausgangszweig der steuerbaren Stromquelle, allerdings nur unter der Voraussetzung, daß der Steuertransistor MP3 nicht abschaltet. MP3 ist jedoch vom Typ komplementär zu MN2 und schaltet nur dann ab, wenn sein Gatepotential zu hoch wird. Unterhalb dieser Schwellspannung stellt MP3 eine Stromquelle bzw. einen Widerstand dar. Bei gut definierten Logikpegeln der digitalen Signalquelle DSQ sperrt also immer einer der beiden Steuertransistoren MN2 oder MP3. In diesem Betriebszustand liefert die steuerbare Stromquelle deshalb keinen Strom.

Die aus den Transistoren MN3 bis MN5 gebildete Feststromquelle liefert andererseits dauernd Strom. Da die beiden Teilstromquellen gegeneinander arbeiten, addieren sich die Teilströme der Teilstromquellen am Ausgang der steuerbaren Stromquellenanordnung. Je nachdem, welche Teilstromquelle ergiebiger ist, liegt der Ausgang der steuerbaren Stromquellenanordnung auf hohem oder niedrigem Potential. In der Alternative a) liegt der Ausgang auf niedrigem Potential, so daß nach Zwischenschaltung der beiden Inverter-Verstärker aus den Elementen MP4 und MN6 bzw. I der Steuereingang des Multiplexers MUX ebenfalls auf niedrigem Potential liegt. Dieser Schaltzustand soll damit gleichbedeutend sein, daß der mit "O" bezeichnete Dateneingang zum Ausgang SA des Multiplexers durchgeschaltet wird. In diesem Fall wird also die digitale Signalquelle DSQ ausgangsseitig über die Steuerklemme SE und den Multiplexer MUX direkt an die Klemme SA durchgeschaltet. In einer vorteilhaften Ausgestaltung ist der Ausgang des Inverters I ebenfalls an einen Steuereingang der weiteren Signalquelle SQ gelegt, der bewirkt, daß ein niedriges Potential die weitere Signalquelle SQ abschaltet. Andererseits wird durch ein hohes Potential die weitere Signalquelle SQ in Betrieb genommen.

In der Alternative b) wird die Steuerklemme SE mit dem Widerstand RSQ beschaltet. Durch den Widerstand RSQ und das Potentialsteuerelement MN1 fließt dann ein Strom, so daß sich an der Steuerklemme SE ein Gleichspannungspotential einstellt. Parasitäre Kapazitäten haben auf das Gleichspannungspotential an der Steuerklemme SE keinen oder einen geringen Einfluß. Sie verbessern allenfalls noch das Verhalten der Schaltungsanordnung vorteilhaft, da sie eine weitere Glättung des an der Klemme SE anliegenden Potentials zur Folge haben.

Da sich durch die Beschaltung mit dem Widerstand RSQ an der Klemme SE ein zwischen den beiden Logikpegeln liegendes mittleres Potential einstellt, werden die beiden Steuertransistoren MN2 und MP3 leitend. Der dann von der steuerbaren Stromquelle lieferbare Strom wird bei einem Steuerpotential in der Nähe einer der beiden Logikschwellen gering und bei einem Mittenpotential vergleichsweise groß sein. Die steuerbare Stromquelle und die Feststromquelle einschließlich der Steuertransistoren und des Potentialsteuerelements werden so dimensioniert, daß über die Eingangspegel an der Steuerklemme SE das Potential am Ausgang der steuerbaren Stromquellenanordnung festgelegt wird. Erfindungsgemäß bedeutet das, daß bei einem angeschlossenen Widerstand RSQ der Ausgang der Stromquellenanordnung auf hohem Potential liegt. Dadurch liegt auch der Ausgang des Inverters I auf hohem Potential, so daß einerseits die weitere Signalquelle SQ eingeschaltet werden kann und andererseits der Steuereingang des Multiplexers MUX auf hohem Potential liegt, so daß die Adresse "1", d.h. der Ausgang der weiteren Signalquelle SQ, zur Ausgangsklemme SA des Multiplexers durchgeschaltet wird. Zur Ergänzung sei angefügt, daß der durch die Elemente MP4 und MN6 gebildete invertierende Verstärker als Schmitt-Trigger ausgebildet sein kann.

Der Widerstand RSQ erfüllt neben der Funktion des Einschaltens der weiteren Signalquelle SQ und des Steuerns des Adresseneingangs des Multiplexers MUX noch eine Funktions als frequenzbestimmendes Element für die weitere Signalquelle SQ. Dies kann beispielsweise dadurch geschehen, daß das Potentialsteuerelement MN1 mit weiteren Elementen in der weiteren Signalquelle einen Stromspiegel bildet und die Frequenz abhängig vom durch den Widerstand RSQ fließenden Strom beeinflußt wird. SQ bildet somit einen spannungsgesteuerten Oszillator (VCO). Beim Anschluß der digitalen Signalquelle DSQ (Alternative a)) an die Steuerklemme SE wird dann allerdings die digitale Signalquelle mit dem durch das Potentialsteuerelement fließenden Strom belastet. Insgesamt können aber die durch die erfindungsgemäße Sensorschaltanordnung entstehenden Verluste vergleichsweise gering gehalten werden.

Bisher wurde vorausgesetzt, daß die an die Steuerklemme SE wahlweise anzuschließende digitale Signalquelle DSQ beim Wechsel zwischen den Logikpegeln eine ausreichende Flankensteilheit aufweist. Ausreichend bedeutet in diesem Zusammenhang, daß der Potentialwechsel zwischen den Logikpegeln schneller erfolgt als den intern vorgegebenen Zeitkonstanten entspricht, so daß die Sensorschaltanordnung nicht umschaltet bzw. die Steuertransistoren MN2 und MP3 die steuerbare Stromquelle dauernd sperren.

Sind jedoch die internen Zeitkonstanten zu klein bzw. die Flankensteilheit der digitalen Signalquelle nicht mehr ausreichend, so liegt beim Pegelwechsel zwischen den logischen Signalpegeln am Steuereingang SE kurzzeitig ein Potential an, das zu einem Stromfluß der steuerbaren Stromquelle führt. Gemäß einer vorteilhaften Ausgestaltung der Erfindung ist vorgesehen, diese kurzzeitigen Störungen durch ein Integrationsglied zu unterdrücken. Dazu ist vorgesehen, an den Ausgang der steuerbaren Stromquellenanordnung am Verbindungspunkt der Ausgangskreise der Transistoren MN3 und MP3 eine Integrationskapazität zu schalten. In einer vorteilhaften Ausführung ist diese Kapazität nicht als diskretes Bauelemente ausgeführt, sondern durch die Geometrie der Transistoren MP4 und MN6 des Inverter-Verstärkers bzw. ggf. eines Schmitt-Triggers ausgebildet. Dazu sind das Verhältnis Kanalweite zu Kanallänge der Transistoren bzw. die Gateflächen vergleichsweise groß gewählt. Auf diese Weise wird die Schwellspannung des Verstärkers einstellbar. Als Anhaltspunkt kann der Hinweis dienen, daß die Kanalweite etwa 2- bis 4-mal und die Kanallänge etwa 4- bis 12-mal so groß ist wie bei den anderen Transistoren der Stromquellenanordnung. Über die Dimensionierung der Transistorgeometrien der erfindungsgemäßen Sensorschaltanordnung können auf diese Weise sowohl die Schwellspannungen der Transistoren als auch die Zeitkonstanten in bestimmten Grenzen unabhängig voneiander eingestellt werden.

## Patentansprüche

1. Sensorschaltanordnung für eine digitale und eine weitere Signalquelle (DSQ, SQ) mit einem Multiplexer (MUX), der abhängig von Signalen an einer Steuerklemme (SE) eine der Signalquellen zum Sensorausgang (SA) durchschaltet, wobei die Steuerklemme (SE) und die weitere Signalquelle (SQ) an die Signaleingänge des Multiplexers (MUX) geführt sind, **dadurch gekennzeichnet,** daß die Steuerklemme (SE) wahlweise mit der digitalen Signalquelle (DSQ) oder mit einem funktionsbestimmenden Element (RSQ) der weiteren Signalquelle (SQ) verbindbar ist und
daß die Steuerklemme (SE) mit dem Eingang einer steuerbaren Stromquellenanordnung (MP1 bis MP3, MN2 bis MN5) verbunden ist, die den Adresseneingang des Multiplexers (MUX) so steuert, daß die digitale Signalquelle (DSQ) bei digitalen Signalpegeln an der Steuerklemme durchgeschaltet wird und daß die weitere Signalquelle (SQ) bei Signalpegeln durchgeschaltet wird, die zwischen den digitalen Signalpegeln der digitalen Signalquelle liegen und mit Hilfe des funktionsbestimmenden Elements (RSQ) abgeleitet sind.

2. Anordnung nach Anspruch 1, **dadurch gekennzeichnet,** daß die steuerbare Stromquellenanordnung (MP1 bis MP3, MN2 bis MN5) eine gegen eine Feststromquelle (MN3 bis MN5) arbeitende steuerbare Stromquelle (MP1 bis MP3, MN2) mit einem Stromspiegel (MP1, MP2) enthält, der in Reihe zu zwei mit der Steuerklemme (SE) verbundenen komplementären Steuertransistoren (MN2, MP3) liegt.

3. Anordnung nach Anspruch 2, **dadurch gekennzeichnet,** daß je einer der Steuertransistoren (MN2, MP3) in Reihe zum Eingangs (MP1)- bzw. Ausgangszweig (MP2) des Stromspiegels liegt.

4. Anordnung nach einem der Ansprüche 1 bis 3, **dadurch gekennzeichnet,** daß der steuerbaren Stromquellenanordnung (MP1 bis MP3, MN2 bis MN5) eine Integrationskapazität (C) nachgeschaltet ist.

5. Anordnung nach Anspruch 4, **dadurch gekennzeichnet,** daß die Integrationskapazität (C) durch die Geometrien der Transistoren eines der steuerbaren Stromquellenanordnung (MP1 bis MP3, MN2 bis MN5) nachgeschalteten Verstarkers (MP4, MN6) oder Schmitt-Triggers ausgebildet wird.

6. Anordnung nach einem der Ansprüche 1 bis 5, **dadurch** **gekennzeichnet,** daß zwischen die Steuerklemme (SE) und eine Bezugsklemme (VSS) ein Potentialsteuerelement (MN1) geschaltet ist.

7. Anordnung nach einem der Ansprüche 1 bis 6, **dadurch gekennzeichnet,** daß die Steuerklemme (SE) mit der weiteren Signalquelle (SQ) verbunden ist.

8. Anordnung nach einem der Ansprüche 1 bis 7, **dadurch gekennzeichnet,** daß der Ausgang der steuerbaren Stromquellenanordnung (MP1 bis MP3, MN2 bis MN5) mit einem Abschalteingang der weiteren Signalquelle (SQ) verbunden ist.

9. Anordnung nach einem der Ansprüche 1 bis 8, **dadurch gekennzeichnet,** daß die Schwellspannungen der Anordnung im wesentlichen durch die Transistorgeometrien bestimmt werden.

10. Anordnung nach einem der Ansprüche 4 bis 9, **dadurch gekennzeichnet,** daß die Zeitkonstanten der Anordnung im wesentlichen durch die Transistorgeometrien bestimmt werden.

## Claims

1. Sensor switching arrangement for a digital signal source (DSQ) and a further signal source (SQ) having a multiplexer (MUX), which connects through one of the signal sources to the sensor output (SA) as a function of signals at a control terminal (SE), the control terminal (SE) and the further signal source (SQ) being connected to the signal inputs of the multiplexer (MUX), characterised in that the control terminal (SE) can optionally be connected to the digital signal source (DSQ) or to a function-determining element (RSQ) of the further signal source (SQ), and in that the control terminal (SE) is connected to the input of a controllable current source arrangement (MP1 to MP3, MN2 to MN5) which controls the address input of the multiplexer (MUX) such that the digital signal source (DSQ) is connected through to the control terminal in the event of digital signal levels, and in that the further signal source (SQ) is connected through in the event of signal levels which lie between the digital signal levels of the digital signal source and are derived with the aid of the function-determining element (RSQ).

2. Arrangement according to Claim 1, characterised in that the controllable current source arrangement (MP1 to MP3, MN2 to MN5) contains a controllable current source (MP1 to MP3, MN2) which operates with respect to a fixed-current source (MN3 to MN5) and has a current balance (MP1, MP2) which is connected in series with two complementary control transistors (MN2, MP3) which are connected to the control terminal (SE).

3. Arrangement according to Claim 2, characterised in that in each case one of the control transistors (MN2, MP3) is connected in series with the input (MP1)- or output branch (MP2), respectively, of the current balance.

4. Arrangement according to one of Claims 1 to 3, characterised in that the controllable current source arrangement (MP1 to MP3, MN2 to MN5) has an integration capacitor (C) connected on its output side.

5. Arrangement according to Claim 4, characterised in that the integration capacitor (C) is formed by the geometries of the transistors of an amplifier (MP4, MN6) or of a Schmitt trigger which is connected on the output side of the controllable current source arrangement (MP1 to MP3, MN2 to MN5).

6. Arrangement according to one of Claims 1 to 5, characterised in that a potential control element (MN1) is connected between the control terminal (SE) and a reference terminal (VSS).

7. Arrangement according to one of Claims 1 to 6, characterised in that the control terminal (SE) is connected to the further signal source (SQ).

8. Arrangement according to Claims 1 to 7, characterised in that the output of the controllable current source arrangement (MP1 to MP3, MN2 to MN5) is connected to a disconnection input of the further signal source (SQ).

9. Arrangement according to one of Claims 1 to 8, characterised in that the threshold voltages of the arrangement are determined essentially by the transistor geometries.

10. Arrangement according to one of Claims 4 to 9, characterised in that the time constants of the arrangement are determined essentially by the transistor geometries.

## Revendications

1. Circuit à détecteur pour une source de signaux numériques et une seconde source de signaux (DSQ, SQ), comportant un multiplexeur (MUX), qui, en fonction de signaux qui sont présents au niveau d'une borne de commande (SE), relie l'une des sources de signaux à la sortie (SA) du détecteur, la borne de commande (SE) et la seconde source de signaux (SQ) étant reliées aux entrées des signaux du multiplexeur (MUX), caractérisé en ce que la borne de commande (SE) est susceptible d'être reliée, au choix, à la source de signaux numériques (DSQ) ou à un élément (RSQ) de la seconde source de signaux (SQ) qui détermine le fonctionnement, et
en ce que la borne de commande (SE) est reliée à l'entrée d'un dispositif de source de courant (MP1 à MP3, MN2 à MN5) qui peut être commandé et qui commande l'entrée d'adressage du multiplexeur (MUX) de telle manière que la source de signaux numériques (DSQ) est branchée, pour des niveaux numériques de signaux présents à la borne de commande et que la seconde source de signaux (SQ) est branchée pour des niveaux de signaux qui se situent entre les niveaux de signaux numériques de la source de signaux numériques et qui sont obtenus à l'aide de l'élément (RSQ) déterminant le fonctionnement.

2. Circuit selon la revendication 1, caractérisé en ce que le dispositif de source de courant susceptible d'être commandé (MP1 à MP3, MN2 à MN5), comporte une source de courant (MP1 à MP3, MN2) susceptible d'être commandée, travaillant contre une source de courant constant (MN3 à MN5) et comportant un miroir de courant (MP1, MP2) qui est monté en série avec deux transistors complémentaires de commande (MN2, MP3), reliés à la borne de commande (SE).

3. Circuit selon la revendication 2, caractérisé en ce que chacun des transistors de commande (MN2, MP3) est monté en série avec la branche d'entrée (MP1) ou la branche de sortie (MP2) du miroir de courant.

4. Circuit selon l'une des revendications 1 à 3, caractérisé en ce que, au dispositif de source de courant (MP1 à MP3, MN2 à MN5) susceptible d'être commandé, est reliée en aval une capacité d'intégration (C).

5. Circuit selon la revendication 4, caractérisé en ce que la capacité d'intégration (C) est formée par la géométrie des transistors d'un amplificateur (MP4, MN6) monté en aval du dispositif de source de courant (MP1 à MP3, MN2 à MN5) susceptible d'être commandé, ou d'une bascule de Schmitt.

6. Circuit selon l'une des revendications 1 à 5, caractérisé en ce qu'un élément de commande du potentiel (MN1) est monté entre la borne de commande (SE) et une borne de référence (VSS).

7. Circuit selon l'une des revendications 1 à 6, caractérisé en ce que la borne de commande (SE) est reliée à la seconde source de signaux (SQ).

8. Circuit selon l'une des revendications 1 à 7, caractérisé en ce que la sortie du dispositif de source de courant (MP1 à MP3, MN2 à MN5) susceptible d'être commandée, est reliée à une entrée de débranchement de la seconde source de signal (SQ).

9. Circuit selon l'une des revendications 1 à 8, caractérisé en ce que les tensions de seuil du circuit sont déterminées essentiellement par les géométries des transistors.

10. Circuit selon l'une des revendications 4 à 9, caractérisé en ce que les constantes de temps du circuit sont déterminées essentiellement par les géométries des transistors.
